# EUROPEAN PATENT APPLICATION

(11) **EP 1 416 325 A1**
(43) Date of publication of application: **06.05.2004**
(21) Application number: 02292687.7
(22) Date of filing: 29.10.2002
(51) Int. Cl.: G03F 7/20, G03F 7/00

(54) **A master and method of manufacturing a master for molds used to produce microstructured devices**

(71) Applicant: CORNING INCORPORATED, Corning, N.Y. 14831 (US)
(72) Inventor: Guzman, Guillaume, 77250 Veneux-les-Sablons (FR); Themont, Jean-Pierre, 77690 Montigny sur Loing (FR)
(74) Representative: Le Roux, Martine

(57) **Abstract**

A method of manufacturing a master from molds used to produce microstructure devices is disclosed. The method comprises the steps of depositing a photoresist on a substrate, and irradiating the photoresist with actinic radiation through a patterned mask at an angle that is non-normal to the surface of the photoresist. A master for molds used to produce microstructure devices is also disclosed.

## Description

### BACKGROUND OF THE INVENTION

### 1. FIELD OF THE INVENTION

The present invention generally relates to microstructures, and more particularly, to a master and method of manufacturing a master used to fabricate such microstructures.

While the present invention is subject to a wide range of applications, it is particularly well suited for making molds that may be used repeatedly for the mass production of microfluidic devices having high aspect ratio features.

### 2. TECHNICAL BACKGROUND

Microstructure devices such as micro-electro-mechanical systems (MEMS), micro-printing plates, and microfluidic devices have been the object of increased research and development efforts over the past decade. Such devices have been fabricated using various types of materials, such as, metals, silicone, polymers, ceramics, and glass. To date, the shortcomings associated with the use of each of these materials have been numerous, particularly when the use envisioned for such devices is the passage of fluids for chemical analysis and chemical processing applications.

Devices made of metal, for example, are liable to corrode, and are typically not compatible with certain biological fluids. Silicone devices are expensive, incompatible with certain biological fluids, and the semiconductive nature of silicone gives rise to problems with implementing certain pumping techniques, such as electro-hydrodynamic pumping and electro-osmotic pumping. Devices made of polymers typically cannot withstand temperatures of more than about 200°C to about 300°C over a prolonged period. In addition, it is often difficult to control surface states effectively within such structures. Moreover, microfabrication techniques for polymer devices are still not well developed.

While microstructures made of glass, glass ceramic, or ceramic materials offer a number of promising characteristics, such as, but not limited to, their insulating nature, their resistance or even inertness in the face of chemical attack, for their transparency, for their surface homogeneity, and for the ease with which their surfaces can be modified chemically, presently available manufacturing techniques have limited their effectiveness. For example, chemical or physical etching technologies generally give rise to hollows in the glass substrate and are not entirely satisfactorily to implement. In addition, micromolding technologies presently available do not generally yield glass, glass ceramic, or ceramic microstructures having high aspect ratio features. Generally speaking, economically feasible manufacturing techniques have rarely resulted in glass, glass ceramic or ceramic microstructures having features that exhibit aspect ratios greater than 1.0. In addition, the demolding step of presently available micromolding processes for glass, glass ceramic or ceramic microstructures typically results in fractured or peeled features due, at least in part, to the negative draft angle that typically results from standard lithographic manufacturing processes.

What is needed therefore, but presently unavailable in the art, is a micromolding process, and in particular, a master for molds used to fabricate microstructures such as microfluidic devices that overcomes these and other shortcomings associated with presently available micromolding technologies. Such a micromolding process and master should be capable of producing microstructures having high aspect ratio features and improved surface smoothness following the demolding step. The method of manufacturing such microstructure devices should be compatible with low cost production while at the same time provide advantageous yields. Moreover, the method of manufacturing a master and the master itself should be well suited for fabricating the microstructures used in the chemical, pharmaceutical, and biotechnology industries. It is to the provision of such a micromolding device and method of manufacturing such a device that the present invention is primarily directed.

### SUMMARY OF THE INVENTION

One aspect of the present invention relates to a method of manufacturing a master for molds used to produce microstructure devices. The method includes the step of depositing a photoresist on a substrate and irradiating the photoresist with actinic radiation through a patterned mask at an angle that is non-normal to the surface of the photoresist.

In another aspect, the present invention is directed to a master for molds used to produce microstructure devices. The master includes a substrate, and a polymerized photoresist affixed to the substrate. The polymerized photoresist defines a structural feature having a positive draft angle.

The method of manufacturing a master for molds used to produce microstructure devices and master of the present invention results in a number of advantages over other micromolding techniques used in the art. For example, the improved lithographic master manufacturing process results in the production of high quality molds that may be used to produce glass, glass ceramic, ceramic, polymeric and microstructures made from other materials which have significantly improved aspect ratios. As a result, microstructures made from the inventive masters exhibit improved channel density and microchannels defined by such microstructures are capable of transporting greater fluid volumes. Moreover, the draft angle of the microstructure features are capable of being controlled. In addition, numerous shortcomings associated with the demolding step have now been overcome.

Additional features and advantages of the invention will be set forth in the detailed description which follows and in part will be readily apparent to those skilled in the art from a description or recognized by practicing the invention as described herein.

It is to be understood that both the foregoing general description and the following detailed description are merely exemplary of the invention, and are intended to provide an overview or framework for understanding the nature and character of the invention as it is claimed. The accompanying drawings are included to provide further understanding of the invention, illustrate various embodiments of the invention, and together with the description serve to explain the principles and operation of the invention.

### BRIEF DESCRIPTION OF THE DRAWINGS

FIG. 1A is a cross-sectional view of a theoretical microstructure microchannel wall manufactured in accordance with a conventional lithographic manufacturing process.

FIG. 1B is a cross-sectional view of a typical microstructure microchannel wall manufactured in accordance with a conventional lithographic manufacturing process.

FIG. 1C is a cross-sectional view of a microstructure microchannel wall manufactured in accordance with the method of the present invention.

FIG. 2-4 schematically illustrate a conventional lithographic master manufacturing process.

FIG. 5 schematically illustrates a method of manufacturing a master for molds used to produce microstructure devices in accordance with the present invention.

FIG. 6 is a cross-sectional view of the master made by the method depicted in Fig. 5.

FIG. 7 schematically depicts a mold being imprint from a master manufactured in accordance with the method of the present invention.

FIG. 8 schematically illustrates preferred method of manufacturing a microstructure device from a mold imprint from a master made in accordance with the present invention.

FIG. 9A-E are photomicrographs depicting various portions of microstructure devices manufactured from molds cast from masters made in accordance with the present invention.

### DETAILED DESCRIPTION OF THE PREFERRED EMBODIMENT

An important issue in the manufacture of microstructure devices, such as, but not limited to, microreaders and other microfluidic devices, is the fabrication of microstructure features having high aspect ratios. Generally speaking, microstructure features, particularly those features made of glass, glass ceramic or ceramic materials, having high aspect ratios, improve channel density and provide for increased fluid volume within microchannels defined, at least in part, by such microstructure features. In addition, such features are typically easier to demold during the manufacturing process as microstructure features having high aspect ratios are less apt to fracture or peal during the demolding step. Moreover, microstructure features having high aspect ratios facilitate the fabrication of thinner microstructure features.

In order to economically manufacture microstructure devices such as microfluidic devices, it is typically necessary to replicate large numbers of such devices without repeating the original manufacturing technique used to fabricate the original mold making device, such as, but not limited to, CNC-machining or lithography. Generally speaking, a mold insert (or master) has to be generated, which may then be used to create a mold that can be used repeatedly to mass produce a number of substantially identical microstructure devices. Unfortunately, conventional master manufacturing techniques typically result in microstructure features having poor surface quality and negative draft angles.

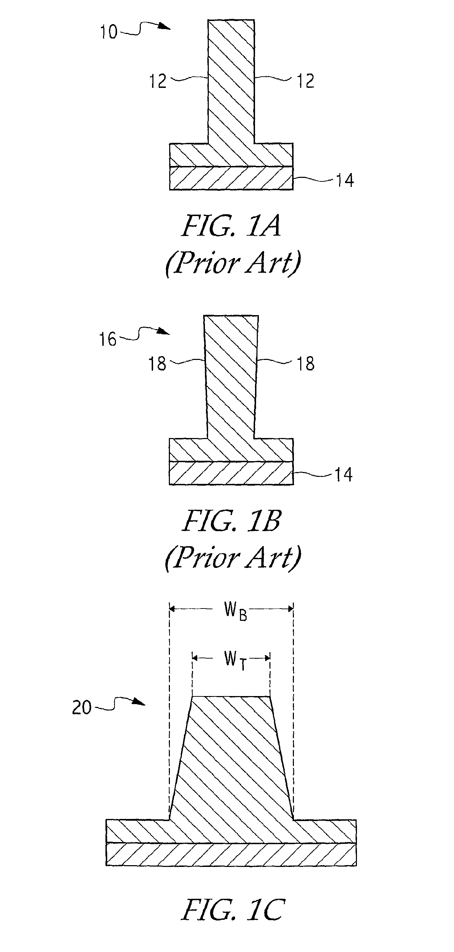

Cross-sectional views of theoretical and actual microstructure features made by traditional lithographic manufacturing techniques are depicted in Figs. 1A and 1B, respectively. As depicted in Fig. 1A, theoretical microstructure feature 10 includes sidewalls 12 that are perpendicular to the surface of substrate 14 on which microstructure feature 10 is supported. As shown in Fig. 1B, actual microstructure feature 16 includes sidewalls 18 that exhibit a negative draft angle with respect to the surface of substrate 14 on which actual microstructure feature 16 is supported. Such an actual microstructure feature 16 has a low aspect ratio and is significantly weaker than a microstructure feature having a high aspect ratio. As used herein, the phrase, "aspect ratio" is used in its conventional sense to refer to the ratio of an objects height to its width (or diameter). Thus, in accordance with the present invention, high aspect ratio microstructure features may be prepared that are extremely narrow or thin relative to their height.

In accordance with one aspect of the present invention, microstructure features may be made from a master manufactured in accordance with the present invention that overcome these and other shortcomings associated with microstructure features manufactured by conventional methods. This is particularly the case when such microstructure features and microstructures are manufactured from glass, glass ceramic and ceramic materials.

An example of such a microstructure feature 20 is depicted in Fig. 1C. Unlike the microstructure features discussed above with reference to Figs. 1A and 1B, preferred microstructure feature 20 manufactured in accordance with the present invention has a positive draft angle. Accordingly, the bottom width W_{B} of microstructure feature 20 is greater than the width of the top (W_{T}) of microstructure feature 20, resulting in a structure having a trapezoidal shape in cross section. As will be explained in greater detail below, the dimensions of microstructure feature 20 may be controlled by the method of manufacturing the master in accordance with the present invention. The trapezoidal shape of microstructure feature 20, among other things, facilitates the manufacture of taller and thinner structures and thus microstructure features 20 having exceptionally high aspect ratios due, at least in part, to wider base widths W_{B} provided by the trapezoidal or other shape.

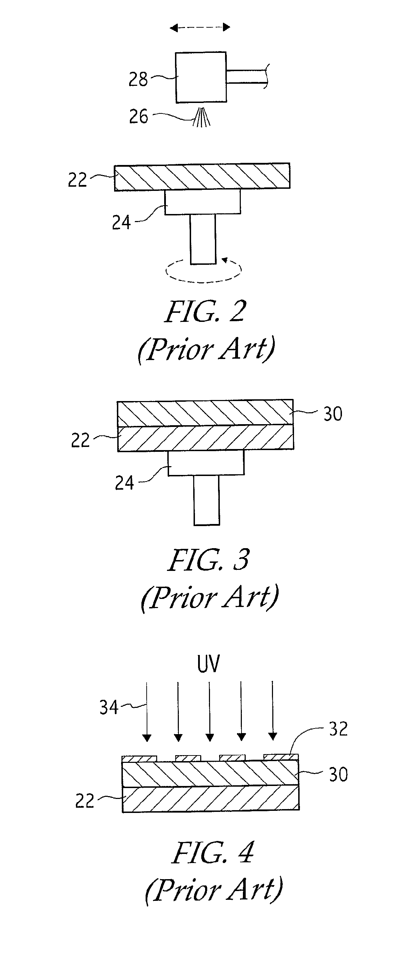

Figs. 2-4 depict a conventional method of manufacturing a master for a mold utilized to fabricate microstructures and microstructure features. As shown in Fig. 2, a substrate 22 supported by support structure 24 may typically be coated with a photoresist 26 supplied by an application mechanism that may be movable across the surface of substrate 22. Generally speaking, support structure 24 and thus substrate 22 is rotated to facilitate even application of a photoresist layer 30 as depicted in Fig. 3. As depicted in Fig. 4, the photoresist 30 carried on substrate 22 may be fitted with a patterned mask 32 and thereafter exposed to some form of actinic radiation such as ultraviolet (UV) light. The UV light passes through the patterned portion of patterned mask 32 thereby polymerizing the portion(s) of photoresist 30 exposed to the UV light. Heretofore, photoresist 30 has been arranged with respect to the source of UV light such that the UV light is imparted on photoresist 30 at an angle normal to the plane of the surface of photoresist 30. As a result, when the non-exposed portions of photoresist 30 are removed from substrate 22, the polymerized microstructure features remaining on substrate 22 after removal of the non-exposed photoresist 30 (not shown) generally have a negative draft angle similar to that shown in microstructure feature 16 depicted in Fig. 1B.

Generally speaking, the draft angle of the master mold depends strongly on the photolithography parameters. When the photoresist is SU-8, the change in side wall profile of the microstructure feature may be caused by the volume change of the SU-8 during polymerization, chemical diffusion of cross linking agents, and various illumination parameters (beam divergence, reflectivity of the substrate, UV-absorption in SU-8, reflections at the SU-8 surface). Under-dose or over-dose may also contribute to the negative or positive dimensional change in the microstructure features, respectively. Thus, given the large number of parameters that must be controlled during the exposure phase, conventional UV-lithography is extremely difficult to control and largely impractical for master fabrication.

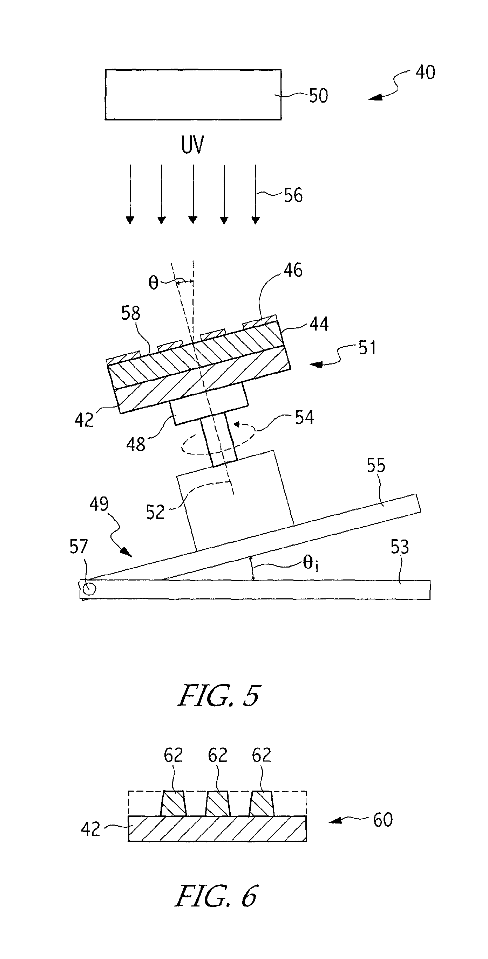

Reference will now be made in detail to the present preferred embodiments of the invention, examples of which are illustrated in the accompanying drawing figures. Wherever possible, the same reference numerals will be used throughout the drawing figures to refer to the same or like parts. An exemplary embodiment of the method of manufacturing a master for molds used to produce microstructure devices is shown in Fig. 5 and is designated generally throughout by reference numeral 40.

In accordance with the method of the present invention, a substrate, preferably formed of aluminum is conventionally coated with a layer of photoresist material. In a preferred embodiment, an aluminum wafer having a diameter of approximately 150.0 millimeters is conventionally spin coated with a 400.0 µm layer of SU-8. As known in the art, SU-8 is a negative, epoxy-type, near-UV photoresist based on EPON-SU-8 epoxy resin (from Shell Chemical) that has been originally developed and patented by IBM. Generally speaking, the SU-8 photoresist can be deposited in a layer up to about 2.0 mn in thickness. Due, at least in part, to its low optical absorption in the UV range, the SU-8 layer is only limited to the 2.0 mn thickness for the 365 nm wavelength where the SU-8 is most sensitive (i.e., where 100% absorption occurs).

As shown in Fig. 5, substrate 42 carrying photoresist 44 is fitted with a patterned mask 46, preferably manufactured from Mylar, and supported on a support structure 48 in proximity to a source of actinic radiation 50. In accordance with a preferred embodiment of the present invention, the target 51, (substrate 42, photoresist 44, patterned mask 46 and support structure 48) is tilted with respect to actinic radiation source 50, and preferably rotated about target axis 52 in the direction of arrow 54. While tilted and rotated, target 51 and specifically photoresist 44 is exposed to actinic radiation 56, preferably 365 nm vertical collimated UV light through patterned mask 46. Those portions of photoresist 44 accessible to actinic radiation 56 through pattern mask 46 are preferably exposed for a time period sufficient to adequately polymerize the exposed photoresist 44.

In accordance with the present invention, actinic radiation 56 is imparted on surface 58 of photoresist 44 at an angle θ of between about 0° and 90°. More preferably, exposure angle θ is between 0° and 45°. Most preferably, exposure angle θ is between about 5° to about 10°. Exposure angle θ is easily controlled by the tilting of target 51 with respect to the source of actinic radiation 50. As a result, photoresist 44 may preferably be polymerized to take on a variety of shapes. For microstructure applications such as microfluidic devices defining one or more microchannels, it is generally preferable to form microfeatures having a trapezoidal shape where the base of the microstructure feature is wider than the top of the microstructure feature. By controlling the tilt of target 51, and thus the exposure angle θ of photoresist 44 to actinic radiation 56, such a result is readily attainable.

Following adequate polymerization as shown in Fig. 5, the non-polymerized (non-exposed) portions of photoresist 44 may preferably be removed, for instance, by chemical solution, to result in a master 60 having features 62 of the desired shape supported on substrate 42 as shown in Fig. 6. Once the appropriate master has been manufactured as described above, a mold may be fabricated from the master using the conventional, "mother-daughter" mold fabrication technique.

In accordance with such a method, a "positive" master 60 is preferably used to produce a "negative" mold 62, preferably constructed of silicone and a stainless steel foil. In accordance with conventional mold manufacturing methods, liquid silicone is preferably poured into the master 60 and covered with a stainless steel foil of approximately 0.2 mn in thickness. Once the silicone has hardened, mold 62 including silicone microstructure forming features 64 and substrate 66, preferably a stainless steel foil, is removed from master 60 such that it has the complimentary imprinting of master 60. Once sufficiently cured, mold 62 may be repeatedly used to mass manufacture a plurality of microstructures having microstructure features, which are complimentary to the features 64 of mold 62.

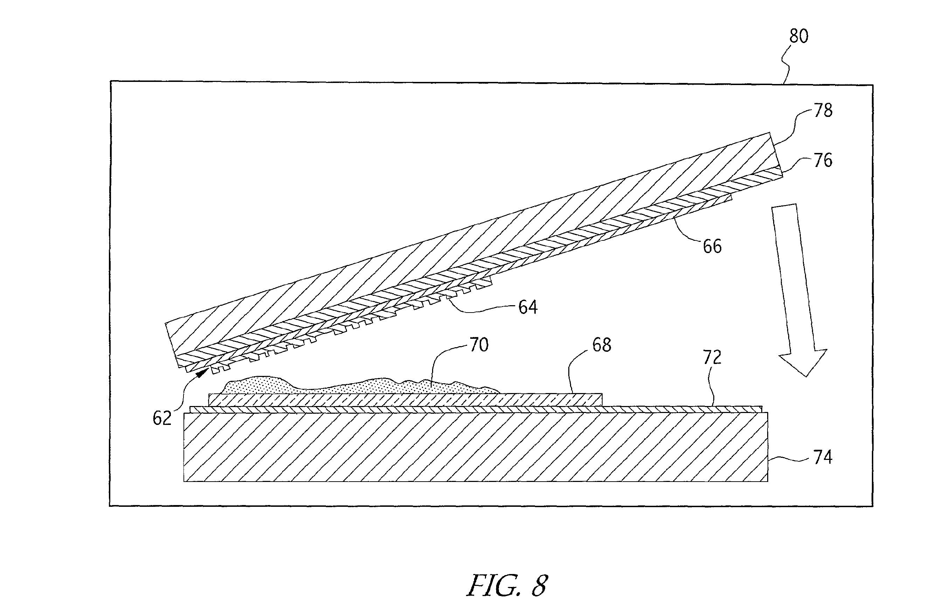

The molding of a microstructure in accordance with the present invention will now be described with reference to Fig. 8. The following method will describe the manufacture of a glass microstructure, and in particular a glass microfluidic device.
One of skill in the art will recognize, however, that the following method may also be applied when manufacturing ceramic and glass-ceramic microstructures as well as microstructures made from other materials.

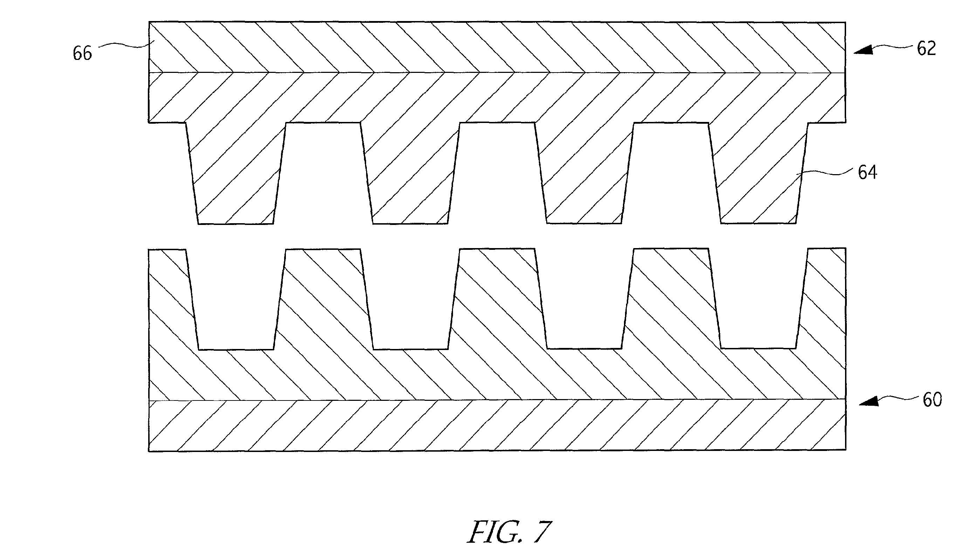

An exemplary embodiment of a method of manufacturing a microstructure having high aspect ratio micro-features in accordance with the present invention is shown in Fig. 8. In a preferred embodiment, microstructures in relief are made on a substrate 68 (e.g. of glass or silicone) with said microstructures being made by molding a mixture 70 including glass frit and a thermaplastic medium (for example). In accordance with the method, mixture 70 is deposited on a glass substrate 68 that is preferably preheated to approximately 100°C. Substrate 68 carrying mixture 70 is preferably placed on a Mylar sheet 72, which is itself placed on a thermostatically controlled support or bed plate 74, preferably preheated to approximately 100°C. A suitable mold 62 including a silicone pattern 64 of suitable design and a stainless steel substrate 66 (preferably a stainless steel foil approximately 0.2 mn thick) is preferably prepared as described above with reference to Fig. 7 and positioned on a support 76, preferably a glass plate, which is itself secured to a thermostatically controlled support or upper plate 78 (also preferably preheated to about 100°C). In accordance with the preferred embodiment of the method, the above-described components are preferably degassed in a vacuum created within an enclosure 80 prior to the mixture 70 being imprint with mold 62 within the enclosure. Such degassing preferably degases the mixture 70 and prevents any bubbles of gas from being trapped in the formed mixture.

Following degassing, upper plate 78 is preferably brought into engagement with lower plate 74 such that silicone micron features 64 of mold 62 is pressed into mixture 70 on glass substrate 68. After a sufficient period of time, and at ambient pressure, upper plate 78 is withdrawn, thereby removing glass plate 76 from stainless steel substrate 66. The components within enclosure 80 are then allowed to return to ambient temperature. Once mixture 70 has sufficiently hardened, mold 62 is removed from mixture 70 and a thermoformed microstructure having a complimentary imprint of micro-features 64 of mold 62 is removed from bed plate 74.

The thermoformed microstructure may then be subjected to heat treatment and consolidated at approximately 520°C so that the newly formed microstructure is presintered. Thereafter, and optionally, a glass or other cover plate containing a thin layer of glass frit may be placed on the presintered microstructure and the assembly may then be exposed to a second heat treatment at approximately 600°C to fully sinter the glass microstructure. If a glass or other cover plate is not utilized (i.e., when the formed microstructure is intended to be an open structure), a second heat treatment at 600°C may immediately follow the initial consolidation of the microstructure.

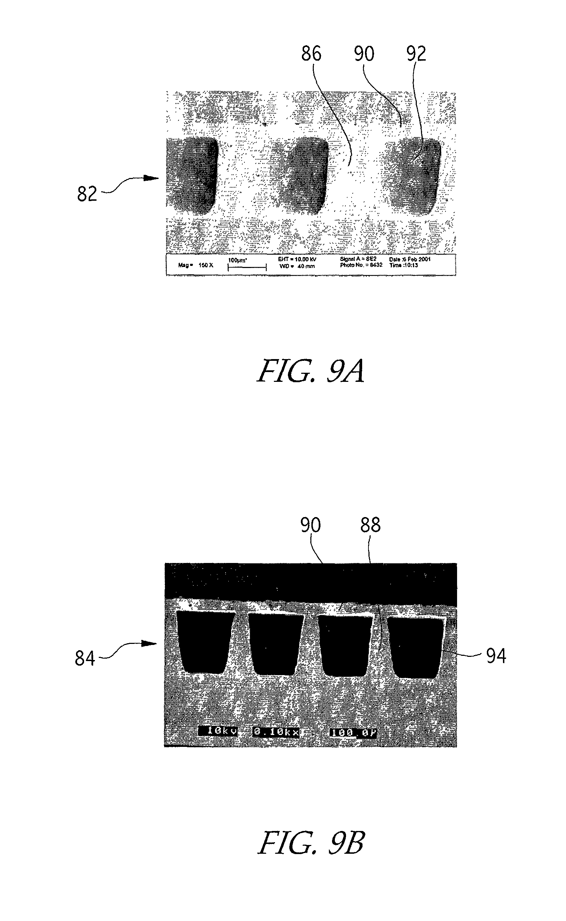

Microstructures having microstructure features such as those depicted in Figs. 9A-9E have been successfully manufactured utilizing the method steps disclosed herein. Microstructures having microstructure features with aspect ratios of 2.0 typically result from the manufacturing process described above. For microstructure features having less than 100 µm of width, aspect ratios of 4.0 may be easily achieved, and it is expected that microstructure features having aspect ratios of 10.0 or higher are attainable in accordance with the present invention. For example, Figs. 9A and 9B depict closed or sealed microstructures 82 and 84, respectively. Microstructures 82 and 84 depicted in Figs. 9A and 9B are glass microstructures having trapezoidal shaped microfeatures 86 and 88, respectively. Each also incorporates a glass cover plate 90. Together, the micro-features 86, 88 (here, microchannel walls) and the glass cover plate 90 define microchannels 92 and 94. Like the micro features 86 and 88, microchannels 92 and 94 have high aspect ratios. More specifically, the height of the microchannels 92, 94 is greater than the width of the bottom portion of the microchannel. In preferred embodiments, microchannels made in accordance with the present invention may range in size from approximately 10.0 µm to approximately 500.0 µm on planer substrates.

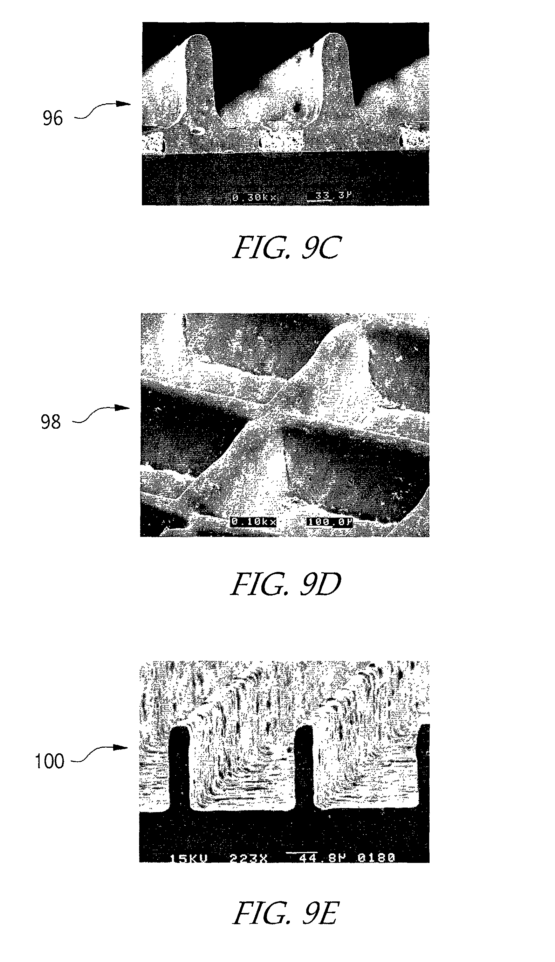

Figs. 9C, 9D and 9E depict open microstructures 96, 98 and 100, respectively.
Again, the glass micro-features depicted in Figs. 9C-9E are preferably made of glass and exhibit high aspect ratios. Those skilled in the art will readily recognize that the micro-features or microchannel walls depicted in Figs. 9C-9E are extremely smooth and have not been adversely affected as a result of the demolding step described above with respect to Fig. 8.

Further details relating to the method of the present invention may be found in co-pending U.S. Nonprovisional Application Serial No. 10/163,215, filed June 4, 2002, and commonly owned by Coming, Inc., which is hereby incorporated by reference.

It will be apparent to those skilled in the art that various modifications and variations can be made to the present invention without departing from the spirit and scope of the invention.

While the present invention has been described in detail, it is to be expressly understood that it will be apparent to persons skilled in the relevant art that the invention may be modified without departing from the spirit of the invention. Various changes of form, design or arrangement may be made to the invention without departing from the spirit and scope of the invention. Therefore, the above mentioned description is to be considered exemplary, rather than limiting and the true scope of the invention is that defined in the following claims.

## Claims

1. A method of manufacturing a master for molds used to produce microstructure devices, the method comprising the steps of:
depositing a photoresist on a substrate; and
irradiating the photoresist with actinic radiation through a patterned mask at an angle that is non-normal to the surface of the photoresist.

2. The method of claim 1 further comprising the step of rotating the substrate during the irradiating step.

3. The method of claim 1 or 2 wherein the irradiating step comprises the step of exposing the photoresist to UV light at an exposure angle of between about 0 degrees and 90 degrees.

4. The method of any one of claims 1 to 3 wherein the irradiating step comprises the step of exposing the photoresist to UV light at an exposure angle of between about 0 degrees and 45 degrees.

5. The method of claim 3 or 4 further comprising the step of rotating the substrate during the exposing step.

6. The method of any one of claims 1 to 5 further comprising the step of removing that portion of the photoresist not exposed to UV light to create structural features having positive draft angles.

7. A master for molds used to produce microstructure devices made by the method of any one of claims 1 to 6.

8. A master for molds used to produce microstructure devices comprising:
a substrate; and
a polymerized photoresist affixed to the substrate, the polymerized photoresist defining a structural feature having a positive draft angle.

9. The master of claim 8 wherein the substrate comprises a metal.

10. The master of claim 9 wherein the substrate comprises aluminum.

11. The master of any one of claims 8 to 10 wherein the polymerized photoresist comprises SU-8.

12. The master of any one of claims 8 to 11 wherein the structural feature defines a trapezoid.

13. The master of any one of claims 8 to 12 wherein the polymerized photoresist defines a plurality of structural features, each having a positive draft angle.

14. The master of any one of claims 8 to 13 wherein the structural feature is formed by exposing a photoresist to UV light through a patterned mask at an angle that is non-normal to the surface of the photoresist.
